# EUROPÄISCHE PATENTSCHRIFT

(11) **EP 3 584 828 B1**
(45) Veröffentlichungstag und Bekanntmachung des Hinweises auf die Patenterteilung: **30.10.2024**
(21) Anmeldenummer: 19189144.9
(22) Anmeldetag: 19.12.2017
(51) Int. Cl.: H01L 23/373

(54) **TRÄGERSUBSTRAT FÜR ELEKTRISCHE BAUTEILE UND VERFAHREN ZUR HERSTELLUNG EINES TRÄGERSUBSTRATS**
CARRIER SUBSTRATE FOR ELECTRICAL COMPONENTS AND METHOD FOR PRODUCING A SUPPORT SUBSTRATE
SUBSTRAT PORTEUR POUR COMPOSANTS ÉLECTRIQUES ET PROCÉDÉ DE FABRICATION D'UN SUBSTRAT PORTEUR

(30) Priorität: 22.12.2016 DE 102016125342
(43) Veröffentlichungstag der Anmeldung: 25.12.2019
(62) Teilanmeldung aus: 17825198.9
(73) Patentinhaber: Rogers Germany GmbH, 92676 Eschenbach (DE)
(72) Erfinder: Gil, Vitalij, 91217 Hersbruck (DE)
(74) Vertreter: Müller Schupfner & Partner Patent- und Rechtsanwaltspartnerschaft mbB (Muc)

(56) Entgegenhaltungen:
- EP-A2- 0 632 681
- EP-A2- 1 523 037
- WO-A1-2013/186267
- DE-A1- 102013 102 540
- DE-A1- 102013 105 528
- DE-A1- 19 927 046
- JP-A- H02 175 674
- JP-A- H09 260 546
- US-A- 5 602 720

## Beschreibung

Die vorliegende Erfindung betrifft ein Trägersubstrat für elektrische, insbesondere elektronische, Bauteile und ein Verfahren zur Herstellung eines Trägersubstrats.

Trägersubstrate sind beispielsweise als Leiterplatten oder Platinen bekannt. Typischerweise werden auf einer Bauteilseite des Trägersubstrats elektrische bzw. elektronische Bauteile und Leiterbahnen angeordnet, wobei die elektrischen bzw. elektronischen Bauteile und die Leiterbahnen zu elektrischen Schaltkreisen zusammenschaltbar sind. Für Spezialanwendungen haben sich solche Trägersubstrate als besonders vorteilhaft erwiesen, die zur elektrischen Isolation der einzelnen elektrischen Bauteile und Leiterbahnen eine Isolationsschicht mit hoher elektrischer Isolationsfestigkeit aufweisen, wie z.B. eine aus Keramik gefertigte Primärschicht.

Im Betrieb dieser Trägersubstrate, insbesondere bei Einsätzen in der Leistungselektronik, werden die elektrischen Bauteile typischerweise derart beansprucht, dass sie erhitzen und sich auf der Bauteilseite lokale Wärmequellen ausbilden. Um durch das Erhitzen veranlasste Schädigungen an den elektrischen Bauteilen oder dem Trägersubstrat zu vermeiden, kennt der Stand der Technik daher Wärmesenken oder Kühlstrukturen, die in der Regel an einer der Bauteilseite gegenüberliegenden Kühlseite, die beispielsweise als an die Primärschicht angrenzende Kupferschicht bzw. Kupferbasis ausgebildet ist, angebracht, z.B. angelötet sind.

Dabei kann das thermomechanische Verhalten des Trägersubstrats im Betrieb in nachteilhafter Weise zu mechanischen Spannungen im Trägersubstrat führen. Bisherige Lösungen, die das thermomechanisches Verhalten des Trägersubstrats insbesondere am Randbereich beeinflussen, wie beispielsweise in der EP 0 632 681 B1, der DE 10 2013 105 528 A1, der DE 199 27 046 B4 oder der DE 10 2013 102 540 A1 beschrieben, schränkten hierbei mitunter einen Nutzungsspielraum der Bauteilseite ein, da auf der Bauteilseite weniger Fläche für die Bestückung vorhanden ist.

Die JP H 09260546 offenbart ein Trägersubstrat für elektrische Bauteile, wobei eine Metallschicht vorgesehen ist, an dessen der Grundkörper des Trägersubstrat zugewandten Seite mehrere gleichmäßig verteilte Ausnehmungen ausgebildet sind.

Aus der JP H02 175 674 A ist ein Trägersubstrat bekannt, dessen Metallisierung am umlaufenden Rand einen derart gestuften Verlauf aufweist, dass an umlaufenden äußersten Rand der Metallisierung ein Rücksprung zwischen Grundkörper und Metallisierung ausgebildet ist.

Die WO 2013 186 267 A1 beschreibt einen Montageträger für Halbleiterchips, der eine für die Montage von Halbleiterchips vorgesehene zweite Hauptfläche und eine der zweiten Hauptfläche gegenüberliegende erste Hauptfläche aufweist. Der Montageträger weist außerdem einen Montagekörper auf, wobei der Montagekörper auf der der ersten Hauptfläche zugewandten Seite eine erste Metallisierung aufweist und die erste Hauptfläche eine Strukturierung mit einer Mehrzahl von säulenartigen Strukturelementen aufweist.

Aus der EP 1 523 037 A2 ist ein Metall-Keramik-Substrat bekannt, das eine Ausnehmung in der Rückseitenmetallisierung aufweist. Die Ausnehmung ist als umlaufende Nut unterhalb des äußersten Rands des Keramikelements ausgebildet.

Die US 5 602 720 A betrifft ebenfalls ein Metall-Keramik-Substrat, das in der Rückseitenmetallisierung eine umlaufende und grabenförmige Ausnehmung aufweist, die bündig abschließt mit dem Keramikelement.

Es ist somit eine Aufgabe der vorliegenden Erfindung, ein Trägersubstrat bereitzustellen, mit dem mechanischen Spannungen entgegengewirkt werden kann, ohne den Nutzungsspielraum auf der Bauteilseite des Trägersubstrats einzuschränken.

Diese Aufgabe wird gelöst durch ein Trägersubstrat für elektrische Bauteile gemäß Anspruch 1 und ein Verfahren gemäß Anspruch 8. Weitere Vorteile und Merkmale der Erfindung ergeben sich aus den Unteransprüchen sowie der Beschreibung und den beigefügten Figuren.

Erfindungsgemäß ist ein Trägersubstrat gemäß Anspruch 1 vorgesehen .

Gegenüber den Trägersubstraten aus dem Stand der Technik hat die erfindungsgemäße Metallschicht den Vorteil, dass die das thermische bzw. das thermomechanische Verhalten beeinflussenden Ausnehmungen auf der der Primärschicht zugewandten Seite, insbesondere unmittelbar an die Primärschicht angrenzend, angeordnet sind. Dadurch wird beispielsweise die Oberfläche, die auf der Bauteilseite zur Anbindung von elektrischen bzw. elektronischen Bauteilen vorgesehen ist, nicht beeinträchtigt bzw. eingeschränkt, sondern steht dem Nutzer vollumfänglich zum Anbringen von elektronischen Bauteilen, Drahtbonds und/oder Terminals für eine Zu- und Ableitung verschiedener elektrischer Ströme und Spannungen zur Verfügung. Gleichzeitig wirken sich die Ausnehmungen positiv auf das Trägersubstrat aus, indem sie abhängig von ihrer Lokalisierung eine Temperaturwechselbeständigkeit des Trägersubstrats bis um das 10-fache steigern oder mechanische Spannungen verteilen, so dass z.B. lokalen mechanischen Spannungsspitzen im Randbereich des Trägersubstrats, insbesondere solche aus der Primärschicht stammende, entgegengewirkt werden kann. Diese Ausnehmungen können ferner in Hinblick auf ihr Volumen vergleichsweise klein gestaltet werden. Dies erlaubt die Anordnung der Ausnehmungen unmittelbar in demjenigen Bereich, in dem die Primärschicht an die Metallschicht angrenzt und in dem die größten thermomechanisch induzierten Spannungen entstehen. Außerdem kann im Herstellungsprozess darauf verzichtet werden, die Ausnehmung von der Bauteilseite ausgehend bis zur Primärschicht in die Metallschicht einzubringen. In einer Ausführungsform umfasst das Trägersubstrat nur die Primärschicht und die mindestens eine Metallschicht, d. h. das Trägersubstrat ist zweilagig ausgestaltet.

Weiterhin bieten die der Primärschicht zugewandten Ausnehmungen größere Freiheitsgrade hinsichtlich ihres Design, d. h. Form und Anordnung, und der Anzahl der eingebrachten Ausnehmungen, da sie unabhängig von der Bauteilseite bzw. Oberfläche sind, insbesondere unabhängig von Vorgaben durch die Bauteilseite. Beispielsweise können mehrere Reihen der Ausnehmungen ausgehend vom Randlauf der Metallschicht in deren Zentralbereich verlaufen. Die Ausnehmungen können sich dabei sowohl über die gesamte Dicke der Metallschicht erstrecken, also durchgängig sein oder dort nur teilweise eingeätzt sein, so dass die Metallschicht an bestimmten Stellen, bevorzugt am Rand, lokal lediglich geschwächt ist. Dadurch wird in vorteilhafter Weise die Fläche spannungsreduzierender Ausnehmungen vergrößert, was es wiederum ermöglicht gegebenenfalls auftretende thermomechanische Spannungen auf eine größere Fläche zu verteilen. Dies vermindert schließlich die Gefahr einer rissauslösenden lokalen Spannungsüberhöhung erheblich. Nach einer Ausführungsform der Erfindung ist die Metallschicht eine strukturierte Metallfläche, wie z. B. eine Leiterbahn, an der zur Bildung eines Schaltkreises elektrische bzw. elektronische Bauteile montierbar sind.

Weiterhin ist es besonderes bevorzugt vorgesehen, dass die Ausnehmungen in die Metallschicht eingeätzt sind. Hierzu werden die Ausnehmungen im Besonderen zeitlich vor dem Fügen der Metallschicht mit der Primärschicht in die Metallschicht eingeätzt und anschließend wird die Metallschicht beim Fügen derart ausgerichtet, dass die Ausnehmungen an der Primärseite anliegen bzw. an der Primärschicht angrenzen. Beispielsweise ist die Primärschicht aus Al₂O₃, Si₃N₄, AIN oder einer HPSX-Keramik (, d. h. einer Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25) gefertigt.

Erfindungsgemäß werden die Ausnehmungen mit einem Füllmaterial befüllt, wobei das Füllmaterial in seinem bestimmungsgemäßen Zustand insbesondere einen niedrigeren Ausdehnungskoeffizient und/oder ein höheres E-Modul als ein Material, aus dem die Metallschicht gefertigt ist, aufweist. Beispielsweise hat das Füllmaterial einen Längenausdehnungskoeffizienten kleiner als Kupfer, d.h. α < 16,5 x 10⁻⁶ K⁻¹, gemessen bei Raumtemperatur. Das Füllmaterial kann dabei in vorteilhafter Weise dazu genutzt werden, einen nachfolgenden Fügeprozess, bei dem das Trägersubstrat in seinen bestimmungsgemäßen Zustand gebracht wird, durch eine stoffschlüssige Verbindung zwischen dem Füllmaterial und der Metallschicht einerseits und zwischen dem Füllmaterial und der Primärschicht anderseits zu unterstützen bzw. zu ermöglichen. Ferner ist es vorstellbar, dass das Füllmaterial derart gewählt ist, dass sich im Bereich des Randverlaufs lokal ein niedrigerer kombinierter Ausdehnungskoeffizient (CTE) einstellt, der die fügetemperaturbedingten thermomechanischen Spannungen beim Abkühlen nach dem Fügeprozess von der Grenzfläche der Primärschicht zur Metallschicht teilweise in die Metallschicht verlagert, in der die thermomechanischen Spannung wiederum während der Abkühlung besser abgebaut werden können. Als Füllmaterialien sind beispielsweise partikelgefüllte Weichlot-, Hartlot- oder Aktivlote vorstellbar, die einen Gehalt von 10 - 64 Vol.-%, vorzugsweise 20 - 50 Vol.-% und besonders bevorzugt 30 - 50 Vol.-% an Keramiken- oder Metallpartikeln mit den oben beschriebenen Eigenschaften enthalten wie z.B. SiC, AIN, Al₂O₃, HPSX, BeO, Si₃N₄, ZnO, TiN, B₄C, Mo, W, Cr, Ta oder Nb.

Die Primärschicht weist insbesondere eine Isolationsschicht mit hoher elektrischer Isolationsfestigkeit auf, bevorzugt von mehr als 5 kV/mm, besonders bevorzugt von
mehr als 10, 20 oder sogar mehr als 30 kV/mm und/oder mit hoher Wärmeleitfähigkeit auf, bevorzugt von mehr als 10 W/mK, besonders bevorzugt von mehr als 20 oder sogar mehr als 60 W/mK, wie z.B. technische Keramiken oder mit wärmeleitenden Materialen gefüllte organische Isolationswerkstoffe.

Vorzugsweise ist es vorgesehen, dass die der Bauteilseite zugewandte Seite der Metallschicht, insbesondere die strukturierte Metallfläche, zumindest bereichsweise eine glatte, d. h. eine ausnehmungsfreie, Oberfläche aufweist. Nach einer Ausführungsform der Erfindung sind die Ausnehmungen derart ausgestaltet, dass eine geschlossene Oberflächenseite der strukturierten Metallfläche, die der Bauteilseite zugewandt ist, größer ist als die Kontaktflächen, über die die strukturierte Metallfläche mit der Primärschicht in Kontakt steht bzw. angebunden ist. Vorstellbar ist auch, dass die Ausnehmungen lochartig und/oder sacklochartig ausgestaltet sind, d. h. die Ausnehmungen greifen durch die Metallschicht durch oder münden bzw. enden, bevorzugt dom- oder kuppelförmig, im Inneren der Metallschicht. Denkbar ist auch eine Ausführungsform, in der lochartige Ausnehmungen und sacklochartige Bohrungen in der Metallschicht realisiert sind, wobei die Anzahl der lochartigen Ausnehmungen kleiner ist als die Anzahl der sacklochartigen Ausnehmungen. Weiterhin ist es bevorzugt vorgesehen, dass in einer senkrecht zur Haupterstreckungsebene des Trägersubstrats verlaufenden Projektionsrichtung bzw. -orientierung unterhalb eines für das Bauteil vorgesehenen Stellplatz bzw. Anbindungsplatz keine oder im Vergleich zur übrigen Metallschicht weniger Ausnehmungen angeordnet sind.

Weitere Vorteile und Merkmale ergeben sich aus der nachfolgenden Beschreibung bevorzugter Ausführungsformen des erfindungsgemäßen Gegenstands. Einzelne Merkmale der einzelnen Ausführungsformen können dabei im Rahmen der Erfindung miteinander kombiniert werden.

Gemäß einer weiteren Ausführungsform der vorliegenden Erfindung ist vorgesehen, dass die Ausnehmung am Randverlauf der Metallschicht angeordnet ist. Der Randverlauf der Metallschicht ist vorzugsweise durch eine Linie festgelegt, entlang der die Metallschicht ihren direkten Kontakt zur Primärschicht beendet. Insbesondere wird der Randverlauf, d.h. die Randlinie, bzw. dessen Oberfläche durch die Ausnehmungen vergrößert, wodurch im Betrieb auftretende mechanische Spannungen, insbesondere solche, die von der Primärschicht herrühren, besser verteilt werden können. Unter Randverlauf ist im Besonderen ein äußerer Umfang der Randschicht in einer parallel zur Haupterstreckungsebene des Trägersubstrats verlaufenden Ebene zu verstehen. In einer Ausführungsform ist die Ausnehmung in einer an der Primärschicht anliegenden Kante der Metallschicht eingelassen. Hierbei verursacht die Ausnehmung im Randverlauf einen maximal um eine Einrücktiefe rückspringenden Konturverlauf. Die durchschnittliche Einrücktiefe, d. h. die über die Ausnehmungen im Randverlauf gemittelten Einrücktiefe, nimmt hierbei einen Wert zwischen 50 µm und 1000 µm ein, bevorzugt zwischen 100 µm und 800 µm und besonders bevorzugt zwischen 150 µm und 600 µm.

Weiterhin ist es beispielsweise vorgesehen, dass für die Ausnehmungen im Randverlauf vorgesehen ist, dass ein Verhältnis einer in Projektionsrichtung bemessenen Tiefe der Ausnehmung zur Einrücktiefe einen Wert zwischen 0,2 und 1,2 annimmt, bevorzugt zwischen 0,3 und 1,0 und besonders bevorzugt zwischen 0,4 und 0,8 annimmt. Gemäß einer weiteren bevorzugten Ausführungsform der vorliegenden Erfindung ist vorgesehen, dass zwischen 10 % und 80 %, bevorzugt zwischen 30% und 80% und besonders bevorzugt zwischen 50 % und 75 % eines den Ausnehmungen zugeordneten Volumens in einem Randbereich angeordnet ist, wobei der Randbereich bevorzugt unabhängig von der Größe des Trägersubstrats gleich groß ist. Der Randbereich ist der Bereich, in dem 60 % - 100 %, bevorzugt 80% - 100% aller Ausnehmungen angeordnet sind.

Vorteilhafterweise bilden mehrere Ausnehmungen, insbesondere mehrere nebeneinander angeordnete Ausnehmungen, einen mäanderförmigen, briefmarkenrandförmigen und/oder einen sägezahnförmigen Randverlauf der Metallschicht aus, wobei sich insbesondere der mäanderförmige, briefmarkenrandförmige und/oder der sägezahnförmige Randverlauf über den gesamten Randverlauf der Metallschicht erstreckt. Vorstellbar ist auch, dass sich der mäanderförmige, briefmarkenrandförmige und/oder sägezahnförmige Randverlauf der Metallschicht nur über einen Teilbereich des gesamten Randverlaufs der Metallschicht erstreckt bzw. mehrere Teilbereich in Umlaufrichtung gesehen zueinander beabstandet aneinander anschließen.

Durch die Ausbildung eines strukturierten Randverlaufs wird dessen Oberflächenvergrößerung so ausgelegt, dass im Wesentlichen unabhängig vom Ort des Auftretens einer mechanischen Spannung diese vorteilhaft verteilt werden kann. Der Randverlauf kann aber auch unregelmäßige Ausnehmungen aufweisen, d.h. z.B. kleine und größere Ausnehmungen, die gemischt oder abwechselnd zueinander angeordnet sind, oder die wellenlienienförmig, rechteckförmig, parallelogrammförmig oder zackig ausgebildet sind. Grundsätzlich ist es bevorzugt vorgesehen, dass sich an den Randverlauf ein geschlossener Streifen der Metallschicht ausbildet, wobei der Streifen insbesondere zu einen Seite hin den mäanderförmigen, briefmarkenrandförmigen und/oder sägezahnförmigen Randverlauf aufweist. Weiterhin ist es vorstellbar, dass innerhalb der Ausnehmungen im Randverlauf zusätzliche Nadel-, Dom- oder Stiftstrukturen angeordnet sind, die die Primärschicht mit der Metallschicht verbinden, um dadurch die mechanische Spannungsverteilung zu homogenisieren bzw. auf eine größere Fläche zu verteilen.

Zweckmäßig ist es vorgesehen, dass die Ausnehmung als Wölbung, insbesondere als kuppelartige oder teilkuppelartige Wölbung, ausgestaltet ist. Die Wölbung ist dabei zu der der Primärschicht abgewandten Seite der angebundenen Metallschicht hin gerichtet. Dadurch wird in vorteilhafter Weise vermieden, dass die Ausnehmungen auf der Primärschicht abgewandten Seite der Metallschicht in Erscheinung treten. So kann die von der Primärschicht abgewandte Seite der Metallschicht vollständig für Bauteile genutzt werden. Insbesondere bilden die Ausnehmungen im Zentralbereich der Metallschicht Hohlräume zwischen der Metallschicht und der Primärschicht aus. Im Randverlauf bildet die Metallschicht beispielsweise in einer senkrecht zur Haupterstreckungsebene verlaufenden Richtung ein Überhang aus. Weiterhin ist es vorstellbar, dass die Ausnehmung in einem Querschnitt, insbesondere in einer parallel zur Haupterstreckungsebene verlaufenden Ebene, oval, karoförmig, rautenförmig oder rillenförmig ausgestaltet ist.

Gemäß einer weiteren Ausführungsform der vorliegenden Erfindung ist vorgesehen, dass die Ausnehmung in einer senkrecht zur Haupterstreckungsebene verlaufenden Richtung eine durchschnittliche Tiefe aufweist, die im Verhältnis zur kleinsten Öffnungsweite der Ausnehmung, beispielsweise einem Durchmesser bei einer kreisförmigen Ausnehmung oder einer Breite einer grabenförmigen Ausnehmung, vorzugsweise einen Wert zwischen 0,2 und 1,2, bevorzugt zwischen 0,3 und 1,0 und besonders bevorzugt von 0,4 bis 0,8 annimmt. Besonders bevorzugt ist es vorgesehen, dass die Ausnehmungen in Hinblick auf das thermische Verhalten des Trägersubstrats möglichst klein sind. Vorstellbar ist auch, dass sich die Ausnehmungen über die gesamte Metallschicht verteilen. Hierbei ist es vorstellbar, dass sich die Tiefen über die gesamte Metallschicht statistische oder willkürlich verteilen. Es ist auch vorstellbar, dass gleichartige Ausnehmungen mit dem kürzeren Abstand zum Randverlauf im Mittel tiefer sind als die Ausnehmungen zum Zentralbereich hin gesehen, beispielsweise um einen Faktor zwischen 1,01 und 3,0, bevorzugt um einen Faktor zwischen 1,1 und 2,5 und besonders bevorzugt um einen Faktor zwischen 1,3 und 2,0. Erfindungsgemäß ist es vorgesehen, dass die Metallschicht im Zentralbereich einen ersten Teilbereich und einen zweiten Teilbereich aufweist, wobei sich die Anzahl der Ausnehmungen und/oder die Tiefe bzw. Größe im ersten Teilbereich von der Anzahl der Ausnehmungen und/oder deren Tiefe bzw Größe im zweiten Teilbereich unterscheidet. Hierbei werden der erste Teilbereich und der zweite Teilbereich abhängig von Trägersubstrat bzw. dessen Einsatzfeld ausgestaltet.

In einer weiteren Ausführungsform ist es vorgesehen, dass sich die durchschnittliche Anzahl und/oder durchschnittliche Tiefe der Ausnehmungen (bezogen auf Flächenabschnitte bzw. pro Teilbereich der Metallschicht) über die Metallschicht gesehen kontinuierlich ändert. Beispielsweise nimmt die Anzahl und/oder Tiefe der Ausnehmung in Richtung Randverlauf des Metallschicht zu oder ab. Weiterhin ist es vorstellbar, dass das Verhältnis zwischen der Tiefe der Ausnehmungen zur Dicke der strukturierten Metallfläche zwischen 2,5 % und 70 %, bevorzugt zwischen 5 % und 60 % und besonders bevorzugt zwischen 10 % und 55 % beträgt. In bestimmungsgemäßer Weise bezieht sich das Verhältnis der Tiefe der Ausnehmungen zur Dicke der Metallschicht auf Metallschichtdicken zwischen 200 µm und 2000 µm, bevorzugt zwischen 250 µm und 1500 µm und besonders bevorzugt zwischen 300 µm und 1000 µm.

In einer weiteren besonders bevorzugten Ausführungsform ist eine Erstausnehmung als durchgängige grabenförmige Vertiefung vorgesehen, die parallel zum Randverlauf der Metallschicht verläuft und kuppelartig in der Metallschicht endet. Unter Erstausnehmung versteht der Fachmann insbesondere die vom Randverlauf gesehen ersten in die Metallschicht eingelassenen und vom Randverlauf beabstandeten Ausnehmungen bzw. eine erste Gruppe von solchen Ausnehmungen. Es können dabei eine oder mehrere durchgängige Erstausnehmungen nebeneinander parallel zum Randverlauf der Metallschicht in die Metallschicht eingebracht werden. Dabei weist die grabenförmige Vertiefung in der Metallschicht einen ersten Abstand vom Randverlauf der Metallschicht von 100 µm bis 1000 µm, bevorzugt 110 µm bis 600 µm und besonders bevorzugt von 150 µm bis 400 µm auf. Alle weiteren Ausnehmungen, die parallel zur durchgängigen gabenförmigen Vertiefung verlaufen, können durchgängig oder als mehrere nebeneinanderliegende diskrete Ausnehmungen gestaltet werden. Ein zweiter Abstand aller weiteren Ausnehmungen zur Ausnehmung weist Werte zwischen 100 µm und 1000 µm, bevorzugt 110 µm und 600 µm und besonders bevorzugt von 150 µm und 400 µm auf. Die Tiefe der Ausnehmungen und die Tiefe der weiteren Ausnehmung ist dabei kleiner als die Dicke der Metallschicht und weisen vorzugsweise Werte zwischen 2,5 % und 70 %, bevorzugt zwischen 5 % und 60 % und besonders bevorzugt zwischen 10 % und 55 % der Metallschichtdicke auf.

Gemäß einer weiteren bevorzugten Ausführungsform sind diskrete Erstausnehmungen vorgesehen, die in Reihe parallel zum Randverlauf der Metallschicht angeordnet sind. Die Erstausnehmungen weisen einen ersten Abstand vom Randverlauf der Metallschicht von 100 µm bis 1000 µm, bevorzugt 110 µm bis 600 µm und besonders bevorzugt von 150 µm bis 400 µm auf. Des Weiteren ist es vorzugsweise vorgesehen, dass sich an diese Reihe mit Erstausnehmungen eine Reihe mit weiteren Ausnehmungen oder sogar mehrere Reihen mit diskreten oder auch in Richtung der Haupterstreckungsebene durchgängigen weiteren Ausnehmungen anschließen. Der Abstand der Erstausnehmungen zur weiteren Ausnehmung ist vorzugsweise 50 µm bis 1000 µm, in bevorzugter Weise 80 µm bis 600 µm und in besonders bevorzugter Weise 100 µm bis 400 µm. Weiterhin ist es vorzugsweise vorgesehen, dass Mittelpunkte der Erstausnehmung und der weiteren Ausnehmungen, bezogen auf die Haupterstreckungsebene der Metallschicht, entlang einer Linie, die sich senkrecht zum Randverlauf der Metallschicht oder unter Bildung eines Winkels zum Randverlauf der Metallschicht, der kleiner ist als 90° , angeordnet sind. Die Tiefe T der Erstausnehmungen und der weiteren Ausnehmungen ist dabei kleiner als die Dicke der Metallschicht und sie weisen Werte von 2,5% und 70%, bevorzugt zwischen 5% und 60% und besonders bevorzugt zwischen 10% und 55% beträgt der Metallschichtdicke auf.

Gemäß einer weiteren Ausführungsform sind Kanäle in der Metallschicht vorgesehen, wobei die Kanäle die Ausnehmungen mit einer das Trägersubstrat umgebenden Umgebung verbinden. Insbesondere werden die Kanäle zusammen, d. h. zeitglich, mit den Ausnehmungen in die Metallschicht eingeätzt und durch das Zusammenfügen der Metallschicht und der Primärschicht werden die Kanäle gebildet. Die Kanäle können in vorteilhafter Weise dazu benutzt werden, Ausnehmungen mit funktionellen Materialien, z.B. organischen Materialien, anorganischen Bindemitteln oder partikelgefüllten Materialien zu befüllen. Dies ist insbesondere deshalb positiv, da die Ausnehmungen vor dem Fügen nicht mit einem Füllmaterial befüllt werden können, weil diese nicht resistent sind gegenüber einer beim Fügen entstehenden Temperaturentwicklung. Das Befüllen mit dem Füllmaterial erweist sich zudem deshalb als vorteilhaft, als dass die Wahrscheinlichkeit für z. B. eine Teilententladung reduziert werden kann. Solche Teilentlandungen können andernfalls in luftgefüllten Bereichen zwischen der Metallschicht und der Primärschicht auftreten.

Vorzugsweise ist es vorgesehen, dass die Metallschicht in Form einer Zwischenschicht zwischen der Primärschicht und einer Sekundärschicht angeordnet ist, wobei insbesondere die Zwischenschicht auf einer der Primärschicht zugewandten ersten Seite und/oder auf einer der Sekundärschicht zugewandten zweiten Seite eine oder mehrere Ausnehmungen aufweist. Die vorher beschriebenen Ausgestaltungen für die Ausnehmungen auf der der Primärschicht zugewandten Seite lassen sich analog auf die Ausnehmungen, die der Sekundärschicht zugewandt sind, übertragen. Vorstellbar ist, dass die Ausnehmung in der Zwischenschicht durchgreifend, beispielsweise als Loch oder Durchgangsbohrung, ausgestaltet ist, wobei sich die Ausnehmung von der Primärschicht bis zur Sekundärschicht erstreckt. Weiterhin ist es bevorzugt vorgesehen, dass die Zwischenschicht dicker ist als die Primär- und/oder Sekundärschicht. Insbesondere ist es vorgesehen, dass das Verhältnis zwischen Tiefe der Ausnehmung in der Zwischenschicht zur Dicke des Zwischenschicht kleiner ist als das Verhältnis zwischen Tiefe der Ausnehmung in der strukturierten Metallfläche zur Dicke der strukturierten Metallfläche. Vorzugsweise umfasst die Zwischenschicht zusätzlich zu den Ausnehmungen eine Hohlkammer innerhalb der Zwischenschicht.

In einer weiteren Ausführungsform der vorliegenden Erfindung ist es vorgesehen, dass Ausnehmungen auf der zweiten Seite in einer senkrecht zur Haupterstreckungsebene verlaufenden Richtung im Wesentlichen deckungsgleich oder versetzt zu den Ausnehmungen auf der ersten Seite der Zwischenschicht angeordnet sind. Durch ein versetztes Anordnen der Ausnehmungen wird eine vergleichsweise widerstandfähige Metallschicht bereitgestellt, da auf eine lokale Schwächung der Metallschicht verzichtet wird. Weiterhin ist es von Vorteil, dass unterhalb von Bauteilen ein ausreichende Größe an Zwischenschicht bereitgestellt werden kann, über die im Betrieb die Wärme von den als Wärmequelle wirkenden Bauteilen wirkungsvoll zur Kühlseite abtransportiert werden kann. Insbesondere ist es vorgesehen, dass die Zwischenschicht in einem an den Randverlauf angrenzenden Bereich auf der ersten und der zweiten Seite einander gegenüberliegende Rillen, insbesondere eingeätzt Rillen, aufweist. Dadurch lässt sich ein in einer parallel zur Haupterstreckungsebene verlaufenden Richtung gesehen, zwischen einer der Rillen und dem äußersten Randverlauf angeordneter Bereich in vorteilhafter Weise als Kontaktelement in Form einer Verdickung bereitstellen. Vorzugsweise ragt diese Verdichtung gegenüber der Primärschicht und/oder der Sekundärschicht vor, um einen möglichst einfachen Zugriff auf das Kontaktelement der Zwischenschicht zu ermöglichen.

In einer vorteilhaften Ausführungsform der vorliegenden Erfindung ist vorgesehen, dass die Metallschicht Teil einer Kühlstruktur ist, wobei die Kühlstruktur vorzugsweise an die Primärschicht oder Sekundärschicht angebunden ist, wobei insbesondere die Ausnehmung in der Metallschicht zur Bildung einer Dehnungsfuge in einem Bereich angrenzend an den Randverlauf der Primärschicht und/oder der Sekundärschicht ausgebildet ist. Erfindungsgemäß ist es vorgesehen, dass die als Dehnungsfuge dienende Ausnehmung nicht von der Primärschicht und/oder Sekundärschicht überdeckt ist. Dadurch ist es in vorteilhafter Weise möglich, dass eine thermische Längsausdehnung der Kühlstruktur nicht zur Ausbildung von mechanischen Spannungen führt, indem die als Dehnungsfuge dienende Ausnehmung die Längsausdehnung der Kühlstruktur auffängt.

Insbesondere ist die Ausnehmung in solche Kühlstrukturen bzw. Teile von Kühlstrukturen eingelassen, die gegenüber der Primärschicht und/oder Sekundärschicht in einer parallel zur Haupterstreckungsebene verlaufenden Richtung überstehen. Dabei ist es vorstellbar, dass die Kühlstruktur einen Basiskörper und einen Stegbereich mit senkrecht zur Haupterstreckungsebene verlaufenden Stegen umfasst. Vorzugsweise umschließt bzw. umgibt die Ausnehmung umlaufend eine Kante der ersten Primärschicht und/oder der Sekundärschicht, insbesondere die Kante der Primärschicht und/oder der Sekundärschicht, die der Kühlstruktur zugewandt ist, d. h. die Ausnehmung bildet einen geschlossenen Graben bzw. eine geschlossen Sicke, die die Kante in der Haupterstreckungsebene umgibt.

Erfindungsgemäß ist es vorgesehen, dass eine zur Primärschicht und/oder Sekundärschicht offene Seite der Aussparung teilweise von der Primärschicht bedeckt ist. Mit anderen Worten, die Ausnehmung kann erfindungsgemäß teilweise in Projektionsrichtung gesehen unterhalb der Primärschicht angeordnet sein. Es ist auch vorstellbar, dass die Kante der Primärschicht bündig an einen Rand, insbesondere den innenliegenden Rand, der Ausnehmung anschließt. Vorzugsweise nimmt ein Verhältnis zwischen einem bedeckten Bereich der offenen Seite zur Breite der Ausnehmung einen Wert zwischen 0,05 und 0,8, bevorzugt zwischen 0,1 und 0,6und besonders bevorzugt zwischen 0,15 und 0,4 an.

Vorzugsweise ist es vorgesehen, dass in einer parallel zur Haupterstreckungsebene verlaufenden Richtung die Ausnehmung in einem Kantenabstand von einer Kante der Primärschicht und/oder der Sekundärschicht beabstandet angeordnet ist, wobei
- der Kantenabstand einen Wert zwischen - -0,5 mm bis 1,5 mm, bevorzugt einen Wert zwischen - -0,25 und 0,8 mm und besonders bevorzugt einen Wert zwischen -0,1 bis 0,3 mm annimmt und/oder
- ein Verhältnis vom Kantenabstand zu einer in derselben Richtung bemessenen Breite der Ausnehmung einen Wert zwischen 0,1 bis 0,9, bevorzugt zwischen 0,25 und 0,75 und besonders bevorzugt zwischen 0,3 und 0,6 annimmt. Vorzugsweise ist die Breite der Ausnehmung zwischen 1 mm und 2 mm groß. Insbesondere ist es vorgesehen, dass der Kantenabstand in einer parallel zur Haupterstreckungsebene verlaufenden Richtung von einem in der Kühlstruktur innenliegenden Rand der Ausnehmung ausgehend bis zur Kante der Primärschicht und/oder der Sekundärschicht bemessen wird. Mit negativen Werten sind insbesondere solche Ausnehmungen gemeint, deren innenliegender Rand in Projektionsrichtung gesehen unterhalb der Primärschicht und /oder der Sekundärschicht angeordnet ist.

Zweckmäßig ist es vorgesehen, dass ein Verhältnis der Tiefe der Ausnehmung zur Kühlstrukturdicke einen Wert zwischen 0,25 und 0,9, bevorzugt zwischen 0,3 und 0,8 und besonders bevorzugt zwischen 0,45 und 0,7 annimmt
Ein weiterer Gegenstand der vorliegenden Erfindung ist ein Verfahren zur Herstellung eines Trägersubstrats, insbesondere eines Trägersubstrats gemäß einem der vorhergehenden Ansprüche, umfassend die Schritte:
- Bereitstellen einer aus Keramik gefertigten Primärschicht und mindestens einer Metallschicht
- Ausformen, insbesondere Einätzen, von Ausnehmungen in die mindestens eine Metallschicht und
- Fügen der Primärschicht und der mindestens einen Metallschicht, wobei die mindestens eine Metallschicht derart ausgerichtet wird, dass in einem gefertigten Zustand die Ausnehmungen der Primärschicht zugewandt sind.

Sämtliche für das erfindungsgemäße Trägersubstrat beschriebenen Merkmale und deren Vorteile lassen sich sinngemäß ebenfalls auf das erfindungsgemäße Verfahren übertragen und andersrum. Als Fügeverfahren bzw. Verbindungsmethode ist ein DCB-Verfahren, ein Aktivlöten, ein Hartlöten oder ein Kleben vorstellbar.

Gemäß einer weiteren Ausführungsform der vorliegenden Erfindung ist es vorgesehen, dass zeitlich vor dem Fügen die Metallschicht gefaltet wird. Insbesondere ist es vorgesehen, dass gezielt Ausnehmungen, vorzugsweise ausschließlich, auf einer Seite in der Metallschicht realisiert werden und anschließend durch das Falten die Zwischenschicht mit Ausnehmungen, die im gefertigten Zustand der Primärschicht und der Sekundärschicht zugewandt sind, bereitgestellt wird. Dadurch lässt sich in vorteilhafter Weise auf ein aufwendiges beidseitiges Einätzen von Ausnehmungen in die Metallschicht verzichten. Besonders bevorzugt ist es vorgesehen, dass die Ausnehmungen derart in die Metallschicht eingeätzt werden, dass die Ausnehmungen im gefalteten Zustand in einer senkrecht zur Haupterstreckungsebene verlaufenden Richtung im Wesentlichen deckungsgleich zueinander oder versetzt zueinander angeordnet sind.

Alternativ ist es auch vorstellbar, zwei oder mehrere Teilsubstrate getrennt in einem ersten Schritt mit bereits erwähnten Fügemethoden zu fertigen, wie beispielsweise die Primärschicht mit der strukturierten Metallfläche und einem Teil der metallischen Zwischensicht, sowie die Sekundärschicht mit einem Teil der metallischen Zwischenschicht und der Kühlstruktur. Diese mindestens zwei Teilsubstrate bzw. Einzellaminate werden in mindestens einem weiteren, z.B. zweiten Fügeschritt, zum erfindungsgemäßen Substrat gefügt, mittels gängiger Fügeprozesse wie z.B. DCB Verfahren, Hartlöten, Weichlöten, Diffusionsschweißen oder einem Sinterprozess.

Weiterhin ist es bevorzugt vorgesehen, dass die Metallschicht beidseitig, vorzugsweise gleichzeitig oder zeitlich überlappend, eingeätzt wird. Dadurch ist es in vorteilhafter Weise möglich, beim Einbringen der Ausnehmungen, bereits Isogräben, die insbesondere für Leiterbahn vorgesehen sind, ganz oder teilweise von beiden Seiten der Metallschicht einzuätzen. Dadurch lässt sich der Herstellungsprozess in vorteilhafter Weise beschleunigen. Zudem sind im Vergleich zum Stand der Technik engere Strukturen bzw. Ausnehmungen zwischen den Metallflächen des Layouts bzw. den strukturierten Metallflächen realisierbar. Weiterhin können dickere Metalllagen strukturiert werden, da sie anders als im Stand der Technik beidseitig und zueinander deckungsgleich geätzt werden können. Dabei ist unter deckungsgleich zu verstehen, dass die Ausnehmungen in Hinblick auf ihre Mitte fluchtend zueinander angeordnet sind, während die Ausnehmungen unterschiedlich breit sein können. Vorzugsweise ist es vorgesehen, dass eine Breite des Isograbens einen Wert annimmt, der dem Mehrfachen einer Dicke der Metallschicht entspricht, bevorzugt 2-10-fachen, besonders bevorzugt 2-5-fachen einer Dicke der Metallschicht entspricht
Indem die deckungsgleich zueinander angeordneten Ausnehmungen unterschiedlich groß, insbesondere unterschiedlich breit, dimensioniert werden, ist es zudem in vorteilhafter Weise möglich, einen strukturierten Stufenverlauf bzw. eine Stufenätzung zu realisieren. Mit einer solchen Stufenätzung lässt sich die Temperaturwechselbeständigkeit um das 5 bis 10 fache erhöhen.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Es zeigt:
- **Fig.1:**: ein Trägersubstrat gemäß einer Ausführungsform, die nicht Teil der vorliegenden Erfindung ist,in einer Schnittansicht
- **Fig.2:**: das Trägersubstrat aus Fig.1 in einer Draufsicht
- **Fig. 3a und 3b**: ein Trägersubstrate gemäß einer zweiten und dritten bAusführungsform, die nicht Teil der vorliegenden Erfindung ist ,in einer Schnittansicht
- **Fig. 4a bis 4c**: ein Trägersubstrate gemäß einem der vorhergehenden Ansprüche einer vierten, fünften und sechsten Ausführungsform, die nicht Teil der vorliegenden Erfindung ist
- **Fig. 5:**: ein Trägersubstrat gemäß einer ersten Ausführungsform der vorliegenden Erfindung in einer Detailansicht
- **Fig. 6:**: verschiedene beispielhafte Anordnungen der Ausnehmungen in der Metallschicht für ein Trägersubstrat, das nicht Teil der vorliegenden Erfindung ist
- **Fig.7:**: ein beispielhaftes Verfahren zur Herstellung einer Ausnehmung für ein Trägersubstrat, das nicht Teil der vorliegenden Erfindung ist
- **Fig. 8:**: ein weiteres beispielhaftes Verfahren zur Herstellung einer Ausnehmung für ein Trägersubstrat, das nicht Teil der vorliegenden Erfindung ist
- **Fig.9**: ein Trägersubstrat gemäß einer siebten bevorzugten Ausführungsform die nicht Teil der vorliegenden Erfindung ist
- **Fig. 10**: ein weiteres Trägersubstrat gemäß einer achten bevorzugten Ausführungsform die nicht Teil der vorliegenden Erfindung ist
- **Fig. 11**: ein Trägersubstrat gemäß einer neunten bevorzugten Ausführungsform die nicht Teil der vorliegenden Erfindung ist
- **Fig. 12a und 12b**: ein Trägersubstrat gemäß einer zehnten und einer elften bevorzugten Ausführungsform , die nicht Teil der vorliegenden Erfindung ist
- **Fig. 13**: Trägersubstrat gemäß einer zweiten bevorzugten Ausführungsform der vorliegende Erfindung und
- **Fig.14**: Trägersubstrat gemäß einer dritten bevorzugten Ausführungsform der vorliegenden Erfindung.

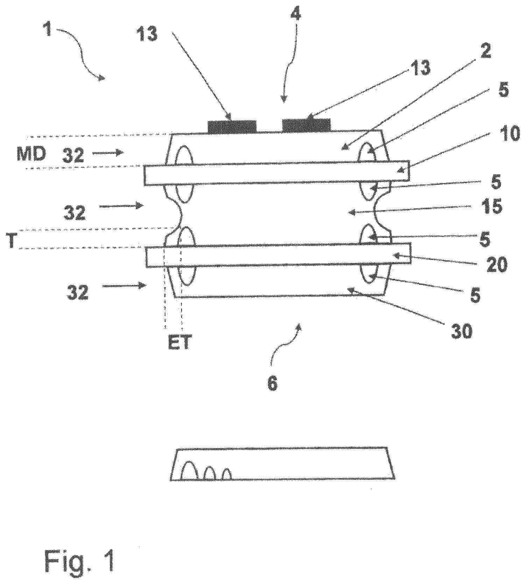

In **Figur 1** ist schematisch ein Trägersubstrat 1 für elektrische Bauteile 13 gemäß einer Ausführungsform, die nicht alle Merkmale des erfindungsgemäß Trägersubstrats umfasst, in einer Schnittansicht dargestellt. Hierbei handelt es sich vorzugsweise um ein für Spezialanwendungen vorteilhaftes keramikhaltiges Trägersubsubstrat 1. Insbesondere weist das Trägersubstrat 1 eine Bauteilseite 4 auf, auf der in Form von strukturierten Metallflächen 2 eine Metallschicht, beispielsweise aus Kupfer oder Aluminium, für elektrische Bauteile 13 bzw. Module vorgesehen ist. Durch das Anbinden von elektrischen Bauteilen 13 an den strukturierten Metallflächen und deren Verbinden lassen sich elektrische Schaltkreise realisieren, mit denen die elektrischen Bauteile 13 ansteuerbar sind. Um einer im Betrieb auftretenden und von den elektrischen Bauteilen 13 ausgehenden Wärmeentwicklung, insbesondere einer in Bereichen mit elektrischen Bauteilen 13 lokal auftretenden Wärmeentwicklung, entgegenzuwirken, ist auf einer der Bauteilseite 4 gegenüberliegenden Kühlseite 6 eine in das Trägersubstrat 1 integrierte Kühlstruktur 30 vorgesehen.

Um auf der Bauteilseite 4 für eine elektrische Isolation zwischen den einzelnen strukturierten Metallflächen zu sorgen, ist an der Bauteilseite 4 eine aus Keramik gefertigte Primärschicht 10 vorgesehen. Hierbei ist die Primärschicht 10 plattenförmig ausgestaltet. Zur Ausbildung einer ausreichenden Stabilität bzw. Steifigkeit ist in dieser beispielhaften Ausführungsform neben der Primärschicht 10 eine Sekundärschicht 20 vorgesehen. Hierbei ist es vorgesehen, dass das Material, aus dem die Primärschicht 10 und die Sekundärschicht 20 gefertigt sind, ein Elastizitätsmodul bzw. E-Modul aufweist, das größer ist als dasjenige des Materials, aus dem die strukturierte Metallfläche gefertigt sind. Dabei ist es vorstellbar, dass die Sekundärschicht 20 aus Keramik und/oder Molybdän gefertigt ist. Denkbar ist auch, dass das Trägersubstrat 1 virtuell in ein Primärsubstrat, ein Sekundärsubstrat und vorzugsweise in ein dazwischen befindliches virtuelles Zwischensubstrat bzw. Teil einer Zwischenschicht zerlegbar ist, wobei das Primärsubstrat neben der Primärschicht auch einen Teil der Metallschicht und der Zwischenschicht und das Sekundärsubstrat einen Teil der Kühlstruktur und der Zwischenschicht umfasst. Bei der Dimensionierung wird eine thermomechanische Symmetrie zwischen dem Primärsubstrat und dem Sekundärsubstrat angestrebt, d.h. der thermische Ausdehnungskoeffizient (CTE) beider Substrate soll vorzugsweise gleich oder zumindest ähnlich sein, beispielsweise innerhalb einer Toleranz von +/- 20 % oder bevorzugt +/- 10 %, besonders bevorzugt +/- 5% übereinstimmen. Durch eine entsprechende Auswahl der Materialien in Hinblick auf die Ausdehnungskoeffizienten für das Primärsubstrat und das Sekundärsubstrat lässt sich nicht nur die Steifigkeit des Trägersubstrats 1 in vorteilhafter Weise vergrößern, sondern es wird darüber hinaus etwaigen thermomechanischen Spannungen, die bei der Herstellung des Trägersubstrats 1 oder bei dessen bestimmungsgemäßen Betrieb auftreten, entgegengewirkt.

Um das thermomechanische Verhalten des Trägersubstrats 1 weiter zu verbessern, ist es vorgesehen, dass der Randverlauf 32 der Metallschicht, insbesondere der strukturierten Metallfläche 2, auf der der Primärschicht 10 zugewandten Seite, insbesondere an einer Kante, profiliert bzw. strukturiert ist. Dadurch wird der Randverlauf 32 in vorteilhafter Weise zur Verteilung der auftretenden mechanischen Spannungen ausgelegt. Dabei ist es vorgesehen, dass der strukturierte Randverlauf 32 durch Ausnehmungen 5, insbesondere eingeätzte Ausnehmungen 5, auf der der Primärschicht 10 zugewandten Seite der Metallschicht realisiert ist. In einer bevorzugten Ausführungsform ist es vorgesehen, dass sich die Ausnehmungen 5 hierbei nicht bis zur Bauteilseite der strukturierten Metallfläche 2 erstrecken. Beispielsweise weisen die Ausnehmungen 5 einen Tiefe T zwischen 10 % und 70 % der Schichtdicke MD der strukturierten Metallfläche 2 auf. Dadurch ist die der Bauteilseite 4 zugewandte Oberfläche größer als die Kontaktfläche zwischen Primärschicht 10 und der strukturierten Metallfläche 2, ohne dass auf die Vorteile des strukturierten Randverlaufs 32 verzichtet werden muss. Dies gestattet es in vorteilhafter Weise, dass mehr Nutzfläche für die elektrischen Bauteile 13 bereitgestellt werden kann. Beispielsweise formen hierbei mehrere Ausnehmungen 5, insbesondere mehrere in Umlaufrichtung nebeneinander angeordnete Ausnehmungen 5, einen mäanderförmigen, briefmarkenrandförmigen und/oder einen sägezahnförmigen Randverlauf 32 auf der der Primärschicht 10 zugewandten Seite der strukturierten Metallfläche 2. Vorstellbar ist hierbei, dass sich der strukturierte Randverlauf 32 über den ganzen Randverlauf 32 oder einen Teilabschnitt des Randverlaufs 32 der strukturierten Metallfläche 2 erstreckt. Insbesondere ist es vorgesehen, dass im Bereich der Ausnehmung 5 die der Primärschicht 10 zugewandte Kontaktseite der Metallschicht um eine Einrücktiefe ET zum äußersten Randverlauf 35 der Metallschicht eingerückt ist. Die durchschnittliche Einrücktiefe ET nimmt hierbei einen Wert zwischen 20 µm und 600 µm ein, bevorzugt zwischen 50 µm und 500 µm und besonders bevorzugt zwischen 200 µm und 400 µm an.

Weiterhin ist es vorgesehen, dass die zwischen der Primärschicht 10 und der Sekundärschicht 20 angeordnete als Metallschicht ausgestaltete Zwischenschicht 15 einen strukturierten Randverlauf 32 aufweist, der insbesondere durch mehrere eingeätzte Ausnehmungen 5 auf der der Primärschicht 10 und/oder der Sekundärschicht 20 zugewandten Seite bzw. deren Kantenverläufen der Zwischenschicht 15 realisiert ist. Insbesondere ist es vorgesehen, dass im Bereich der Ausnehmung 5 die der Primärschicht 10 und/oder der Sekundärschicht 20 zugewandte Kontaktseite der Metallschicht um eine weitere Einrücktiefe ET zum äußersten Randverlauf 35 der Metallschicht eingerückt ist. Vorstellbar ist dabei dass die Einrücktiefe ET der strukturierten Metallfläche 2 und die weitere Einrücktiefe ET der Zwischenschicht 15 im Wesentlichen einander entsprechen oder sich unterscheiden. Denkbar ist auch, dass sich die weitere Einrücktiefe ET auf der der Sekundärschicht 20 zugewandten Seite der Zwischenschicht 15 und die Einrücktiefe ET auf der der Primärschicht 10 zugewandten Seite der Zwischenschicht 15 einander entsprechen oder sich unterscheiden. Weiterhin ist es insbesondere vorgesehen, dass die Ausnehmungen 5 in der strukturierten Metallfläche 2 und die Ausnehmungen 5 in der Zwischenschicht in einer senkrecht zur Haupterstreckungsebene des Trägerelements 1 verlaufenden Projektionsrichtung bzw. -orientierung P deckungsgleich zueinander ausgestaltet sind, oder zueinander versetzt sind.

Zusätzlich zu den strukturierten Randverläufen 32 in der strukturierten Metallfläche 2 auf der Bauteilseite 4 und den strukturierten Randverläufen 32 der Zwischenschicht 15 ist es insbesondere vorgesehen, dass eine auf der Kühlseite 6 an die Sekundärschicht 20 angebundene metallische Kühlstruktur 30 einen durch Ausnehmungen 5 strukturierten Randverlauf 32 aufweist. Vorzugsweise entspricht die Einrücktiefe ET der Ausnehmungen 5 in der strukturierten Metallfläche 2 und/oder die weitere Einrücktiefe ET der Ausnehmungen 5 in der Zwischenschicht 15 einer Einrücktiefe ET in der Kühlstruktur 30. Denkbar ist auch, dass die jeweiligen Einrücktiefen angepasst sind an den individuellen Anwendungsfall, für den das Trägersubstrat 1 vorgesehen ist.

Weiterhin ist es vorstellbar, dass die strukturierten Metallflächen 2, die metallische Zwischenschicht 15 und die Kühlstruktur 30 aus den Metallen Cu, Al , Mo, W, Ag, aus Legierungen oder Verbundwerkstoffen aus den genannten Metallen, aus speziellen Legierungen wie z.B. Invar oder Kovar oder aus mit keramischen Partikeln gefüllten Verbundwerkstoffen der besagten Metalle gefertigt sind. Vorzugsweise werden die strukturierten Metallflächen 2, die metallische Zwischenschicht 15 und die Kühlstruktur 30 aus Kuper oder aus Aluminium oder Cu und/oder Al enthaltenden Legierungen und/oder Verbundwerkstoffen gefertigt. Weiterhin ist es bevorzugt vorgesehen, dass die Primärschicht 10 Al₂O₃, mit ZrO₂ umwandlungsverstärktem Al₂O₃, Si₃N₄, AIN, SiC, HPSX und/oder BeO aufweist. Die Sekundärschicht 20 ist vorzugsweise aus einer der vorgenannten Keramiken oder Molybdän gefertigt.

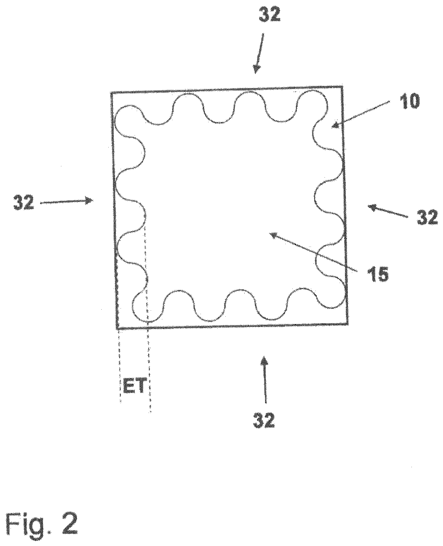

In **Figur 2** ist ein Randverlauf 32 der strukturierten Metallfläche 2, der Zwischenschicht oder Kühlstruktur aus der Figur 1 dargestellt. Insbesondere handelt es sich um einen über den gesamten Randverlauf 32 erstreckenden mäanderförmigen Randverlauf.

In den folgenden Figuren sind neben den jeweiligen Schnittansichten eine verkleinerte Draufsicht auf das Trägersubstrat 1 dargestellt. Hierbei ist in der Draufsicht als gestichelte Linie eine Schnittlinie eingetragen, die der jeweiligen Schnittansicht zuzuordnen ist.

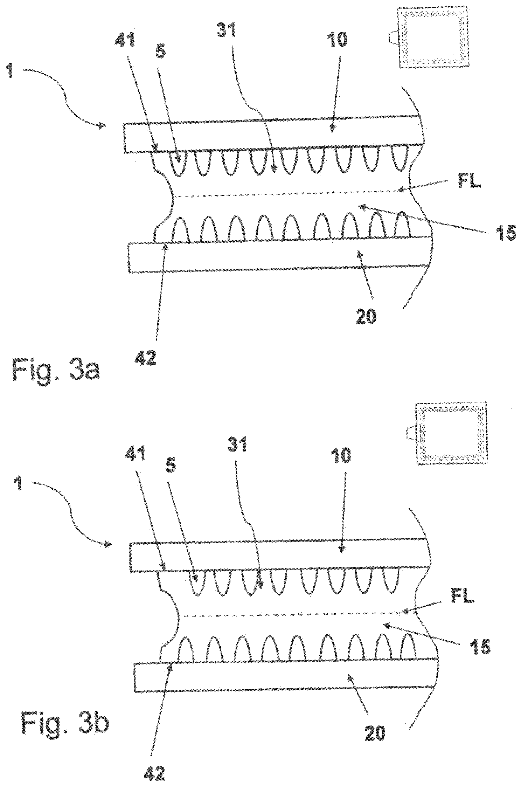

In den **Figuren 3a und 3b** sind eine zweite bevorzugte und eine dritte bevorzugte Ausführungsform der Zwischenschicht 15 eines beispielhaften Trägersubstrats 1, das nicht alle Merkmale des erfindungsgemäß Trägersubstrats umfasst, dargestellt. Dabei ist es vorstellbar, dass die Zwischenschichten 15 der Figuren 3a und 3b in einer zweiten und einer dritten bevorzugten Ausführungsform des Trägersubstrats 1 die Zwischenschicht 15 aus Figur 1 jeweils ersetzen. Insbesondere ist es bei den Zwischenschichten 15 aus den Figuren 3a und 3b vorgesehen, dass die als Zwischenschicht 15 ausgestaltete Metallschicht zusätzlich zu dem strukturierten Randverlauf 32 Ausnehmungen 5, insbesondere kuppelförmige Ausnehmungen 5, auf der der Primärschicht 10 und/oder der Sekundärschicht 20 zugewandten Seite in einem Zentralbereich 31 aufweist. Dabei sind die Ausnehmungen 5 derart ausgestaltet, dass sie zusammen mit der Primärschicht 10 und/oder Sekundärschicht 20 einen Hohlraum zwischen der Metallschicht und der Primärschicht 10 und/oder der Sekundärschicht 20 ausbilden. Vorzugsweise weisen die kuppelförmigen Ausnehmungen 5 einen im Wesentlichen kreisförmigen Querschnitt auf, deren Durchmesser zwischen 100 µm und 1000 µm, bevorzugt zwischen 110 µm und 800 µm und besonders bevorzugt zwischen 150 µm und 600 µm liegt. Dabei ist es vorstellbar, dass die Ausnehmungen 5 alle im Wesentlichen den gleichen Durchmesser aufweisen oder dass sich die Größen für die Durchmesser statistisch bzw. willkürlich verteilen. Alternativ oder ergänzend ist es vorstellbar, dass in die Zwischenschicht 15 Bohrungen eingelassen sind, die von der Primärschicht 10 zur Sekundärschicht 20 führen. Denkbar ist auch, dass in die Zwischenschicht 15 sowohl Ausnehmungen 5 als auch lochartige, d. h. durch die Zwischenschicht durchgreifende, Ausnehmungen eingelassen sind, wobei das Verhältnis zwischen lochartigen Ausnehmungen zu sacklochartigen Ausnehmungen kleiner 1, gleich 1 oder größer 1 ist.

Weiterhin ist es vorgesehen, dass bei der Herstellung der Zwischenschicht 15 Ausnehmungen 5 auf einer Seite einer Metallschicht realisiert werden und anschließend die Metallschicht zur Bildung der Zwischenschicht 15 gefaltet wird. Dabei formt die gefaltete Metallschicht eine Faltlinie FL aus und die Ausnehmungen 5 liegen auf zueinander gegenüberliegenden Seiten der Zwischenschicht 15. In der Ausführungsform in der Figur 3a ist es vorgesehen, dass in einer senkrecht zur Haupterstreckungsebene verlaufenden Richtung gesehen die Ausnehmungen 5 auf der der Primärschicht 10 zugewandten erste Seite 41 deckungsgleich zu den Ausnehmungen 5 auf der der Sekundärschicht 20 zugewandten zweiten Seite 42 angeordnet sind. In der Figur 3b sind die Ausnehmungen 5 auf der der Primärschicht 10 zugewandten Seite zu den Ausnehmungen 5 auf der der Sekundärschicht 20 zugewandten Seite entlang einer parallel zur Haupterstreckungsebene verlaufenden Richtung versetzt. Weiterhin ist es für die Zwischenschichten 15 aus den Figuren 3a und 3b vorgesehen, dass der Randverlauf 32 in einer parallel zur Haupterstreckungsebene verlaufenden Richtung gegenüber der Primärschicht 10 und/oder der Sekundärschicht 20 vorsteht. Dadurch lässt sich mit dem vorstehenden Abschnitt der Zwischenschicht 15 in vorteilhafter Weise ein Kontaktelement 16 bereitstellen, mit dem ein Strom in die Zwischenschicht 15 eingeleitet werden kann.

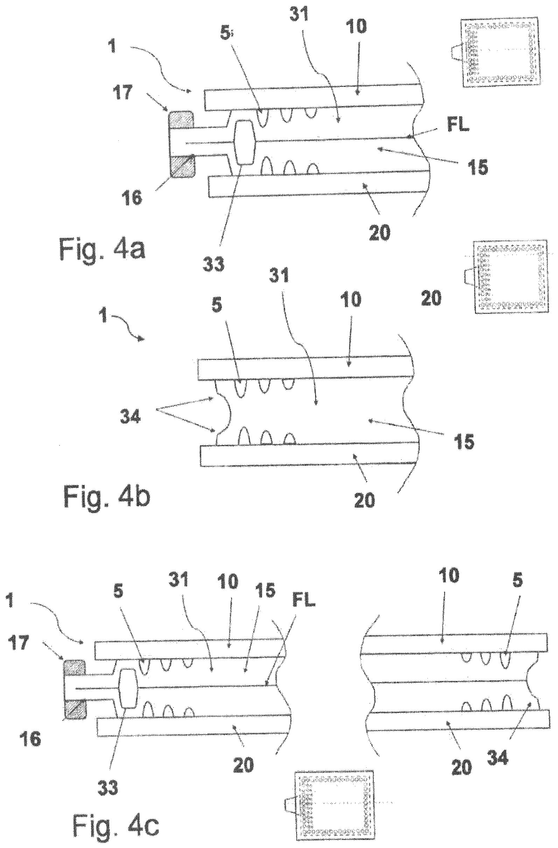

In den **Figuren 4a und 4b** sind eine vierte bevorzugte und eine fünfte bevorzugte Ausführungsform der Zwischenschicht 15 eines beispielhaften Trägersubstrats 1 , das nicht alle Merkmale des erfindungsgemäß Trägersubstrats umfasst, dargestellt. Dabei ist es vorstellbar, dass die Zwischenschichten 15 der Figuren 4a und 4b in einer vierten und einer fünften bevorzugten Ausführungsform des Trägersubstrats 1 die Zwischenschicht 15 aus Figur 1 jeweils ersetzen. Hierbei ist es vorgesehen, dass die Zwischenschicht 15 eine Ausnehmung 5 innerhalb der Zwischenschicht 15 aufweist. Ein solche Hohlkammer 33 lässt sich beispielsweise dadurch herstellen, dass zwei Ausnehmungen 5 auf einer Metallschicht eingeätzt werden und anschließend die Metallschicht zur Ausbildung des Hohlraums innerhalb der Zwischenschicht 15 so gefaltet wird, dass die zwei Ausnehmungen 5 auf der Faltseite bzw. entlang der Faltlinie FL in Projektionsrichtung bzw. -orientierung P gesehen deckungsgleich zueinander angeordnet sind. Dabei können die zwei den Hohlraum formenden Ausnehmungen 5 beispielsweise rillenförmig und/oder kuppelförmig ausgestaltet sein.

Weiterhin ist es vorgesehen, dass die Zwischenschicht 15 im vorstehenden Abschnitt, der zur Bildung eines Kontaktelements 16 vorgesehen ist, eine Verdickung 17 aufweist. Beispielsweise lässt sich die Verdickung 17 durch einen zum Randverlauf 32 der Zwischenschicht 15 parallel verlaufenden Ätzgraben realisieren, der auf der der Primärschicht 10 zugewandten Seite und/oder auf der der Sekundärschicht 20 zugewandten Seite der Zwischenschicht 15 angeordnet ist. Denkbar ist auch, dass in die Metallschicht zwei Ätzgräben eingelassen werden und durch ein anschließendes Falten der Metallschicht die Verdickung 17 am Randverlauf der Zwischenschicht 15 realisiert wird. In der Figur 4b ist der Randverlauf 32 der Zwischenschicht 15 nach innen gewölbt. Eine solche gestufte Kante 34 lässt sich beispielsweise durch ein Erodieren der Seitenfläche der Zwischenschicht 15, die weder der Primärschicht 10 noch der Sekundärschicht 20 zugewandt ist, oder bei der Darstellung einer faltbaren Zwischenschicht 15 mit gestuften Randverlauf durch Ätzen realisieren.

Weiterhin ist es vorstellbar, dass gegenüberliegende Ränder der Zwischenschicht 15 mit unterschiedlich breiten Ausnehmungen versehen werden, so dass zeitlich nach dem Falten in einer senkrecht zur Haupterstreckungsebene verlaufenden Richtung ein gestufter Randverlauf an der Seitenwand der Zwischenschicht 15 entsteht. Weiterhin ist es vorstellbar, dass in dem Bereich, der im gefertigten Zustand die Faltkante bildet oder der unmittelbar daran angrenzt, eine weitere Ätzung erfolgt, um dadurch beim späteren Falten andernfalls entstehende mechanische Spannungen zu vermeiden.

Weiterhin ist es in einer sechsten bevorzugten Ausführungsform der Zwischenschicht 15 vorgesehen, dass der Randverlauf 32 der Zwischenschicht 15 derart gestaltet ist, dass die Zwischenschicht 15 auf einer Seite einen gegenüber der Primärschicht 10 und/oder der Sekundärschicht 20 vorstehenden Abschnitt aufweist und auf der gegenüberliegenden Seite einen nach innen gewölbten Randbereich, d. h. eine gestufte Kante 34.

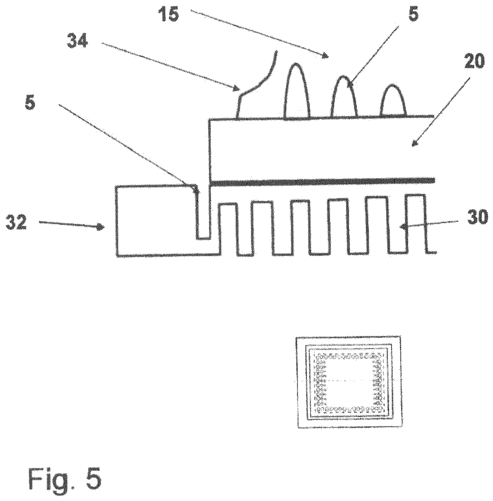

In der **Figur 5** ist eine Metallschicht für ein erstesbevorzugtes Trägersubstrat 1 gemäß der vorliegenden Erfindung dargestellt. Hierbei ist es vorgesehen, dass die Ausnehmung 5 auf der der Sekundärschicht 20 und/oder der Primärschicht 10 zugewandten Seite der als Kühlstruktur 30 ausgestalteten Metallschicht angeordnet ist. Insbesondere ist es vorgesehen, dass die Ausnehmung 5 in einer parallel zur Haupterstreckungsebene verlaufenden Richtung gegenüber der Primärschicht 10 und/oder Sekundärschicht 20 versetzt angeordnet ist, wobei die Kühlstruktur 30 gegenüber der Primärschicht 10 und/oder der Sekundärschicht 20 vorsteht. Insbesondere ist es vorgesehen, dass die Ausnehmung als Dehnungsfuge ausgestaltet ist, um zu vermeiden, dass die thermische Ausdehnung der Kühlstruktur 30 mechanische Spannungen im gesamten Trägersubstrat 1 veranlasst.

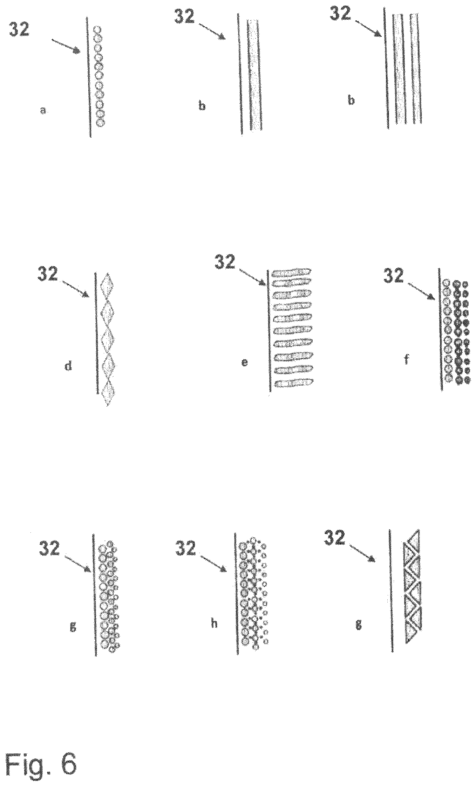

In **Figur 6** sind verschiedene Anordnungen der Ausnehmungen 5 in der Metallschicht dargestellt. Dabei sind verschiedene Querschnittsformen und Anordnungen in Mustern vorstellbar. Neben kreisförmigen Querschnitten, ist auch ein rechteckiger, ein karoförmiger, ein wellenförmiger und/oder ein dreieckiger Querschnitt denkbar (erste und zweite Reihe). Zudem zeigt die Figur 6 Ausführungsformen, in denen kreisförmige Querschnitte mit unterschiedlichen Durchmessern in verschiedenen Mustern angeordnet sind (zweite und dritte Reihe). Vorzugsweise sind die kreisförmigen Querschnitte mit unterschiedlichen Durchmessern versetzt zueinander angeordnet.

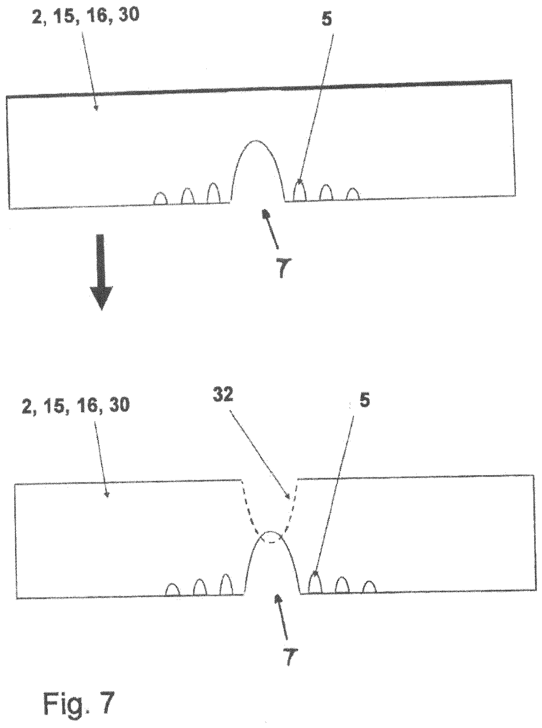

In der **Figur 7** ist beispielhaft ein Verfahren zur Herstellung einer Ausnehmung 5 schematisch dargestellt. Hierbei ist es vorgesehen, dass die Metallschicht beidseitig eingeätzt wird, d. h. ein Ätzprozess findet sowohl auf der im gefertigten Zustand der Primärschicht 10 anliegenden als auch auf der gegenüberliegenden Seite der Metallschicht, insbesondere der Zwischenschicht 15, statt. Wie der Figur 7 zu entnehmen ist, wird hier als erstes die Ausnehmung 5 auf der der Primärseite 10 zugewandten Seite geätzt und anschließend ein Isograben 7, der insbesondere zur Ausbildung einer Leiterbahn vorgesehen ist, geätzt. Vorstellbar ist auch, dass diese Ätzprozesse zeitgleich oder zeitlich überlappend erfolgen. Durch das beidseitige Ätzen ist es in vorteilhafter Weise zudem möglich, den gesamten Herstellungsprozess des Trägersubstrats 1 zu beschleunigen und schmale Isogräben 7 zu realisieren.

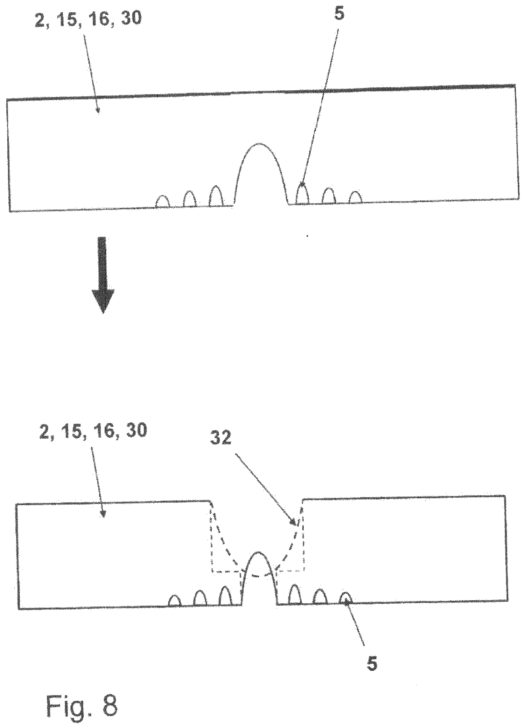

In der **Figur 8** ist beispielhaft ein weiteres Verfahren zur Herstellung einer Ausnehmung schematisch dargestellt. Dabei stimmt das Verfahren im Wesentlichen mit dem aus Figur 7 über. Ein Unterschied besteht allerdings in der Dimensionierung der gegenüberliegenden Ätzungen. Dabei ist es bevorzugt vorgesehen, dass der Ätzprozess auf der Seite der Metallschicht, die im gefertigten Zustand an der Primärschicht 10 anliegt, weniger intensiv ist als der Ätzprozess auf der gegenüberliegenden Seite. Dadurch ist die Ausnehmung 5 auf der der Primärschicht 10 zugeordneten Seite kleiner als die auf der gegenüberliegenden Seite. Indem die einander gegenüberliegenden Ätzungen hierbei unterschiedlich dimensioniert sind, ist es in vorteilhafter Weise möglich, eine Stufenätzung zu verwirklichen, mit der sich die Temperaturwechselbeständigkeit um einen Faktor zwischen 5 bis 10 verbessern lässt.

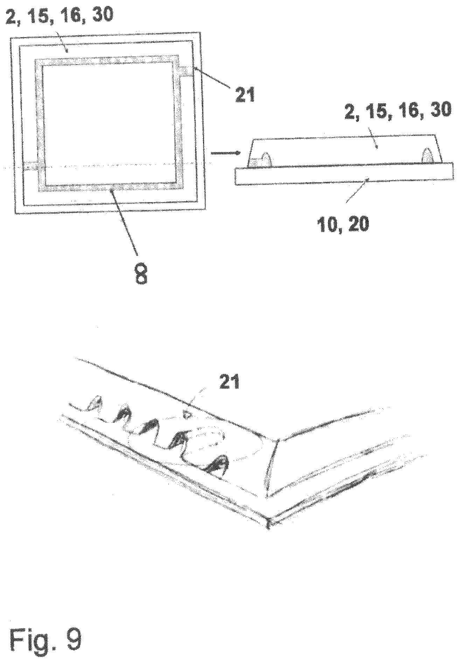

In der **Figur 9** ist ein Trägersubstrat 1 gemäß einer siebten beispielhaften Ausführungsform, die nicht alle Merkmale des erfindungsgemäßen Trägersubstrats umfasst, in einer Detailansicht dargestellt. Das in der Figur 8 dargestellte Trägersubstrat 1 umfasst einen geschlossenen Ätzgraben 8, der sich parallel zum Randverlauf des Trägersubstrats 1 erstreckt. Weiterhin umfasst das Trägersubstrat 1 einen Eingangskanal 21 und einen Ausgangskanal 22, die in die Metallschicht eingelassen sind und die den geschlossenen Ätzgräben 8 mit einer das Trägersubstrat 1 umgebenden Umgebung verbinden. Über den Eingangskanal 21 ist es in vorteilhafter Weise möglich, nach dem Fügen der Primärschicht 10 mit der Metallschicht Füllmaterial in die geschlossenen Ätzgraben 8 einzuleiten. Insbesondere kann der Eingangskanal 21 vorteilhafter Weise dazu benutzt werden, den geschlossenen Ätzgraben 8 oder weitere Ausnehmungen 5 mit funktionellen Materialien, z.B. organische Materialien, anorganischen Bindemitteln oder partikelgefüllten Materialien zu befüllen. Die Befüllung nach dem Fügen ist insbesondere deshalb positiv, da die Ausnehmungen 5 zeitlich vor dem Fügen nicht mit einem Füllmaterial befüllt werden können, weil diese nicht resistent sind gegenüber einer beim Fügen entstehenden Temperaturentwicklung.

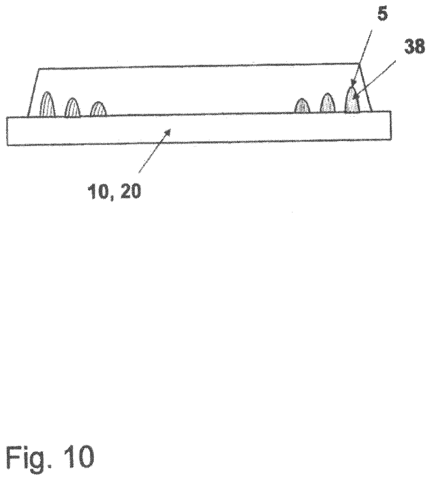

Die **Figur 10** zeigt ein weiteres Trägersubstrat 1 gemäß der achten bevorzugten Ausführungsform das nicht alle Merkmale des erfindungsgemäßen Trägersubstrats 1 umfasst.. Es zeigt das Trägersubtrat 1 aus Figur 9 in einer Schnittansicht, wobei die Ausnehmungen 5 mit dem Füllmaterial 38 bereits vor dem Fügen gefüllt werden.

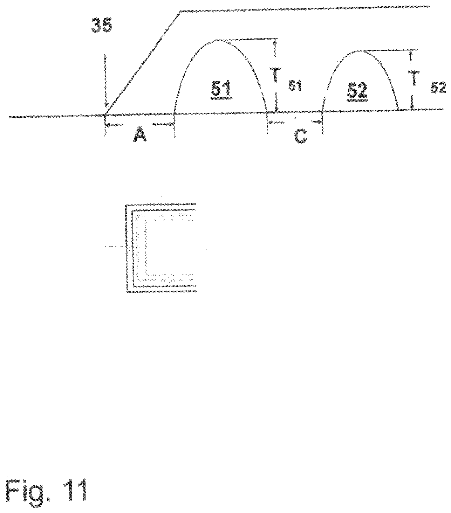

**Die** **Figur 11** zeigt eine Schnittansicht durch eine Metallschicht 2, 15, 30 für ein Trägersubstrat 1 gemäß eine neunten Ausführungsform, das nicht alle Merkmale des erfindungsgemäßen Trägersubstrats umfasst,. Hierbei ist eine durchgängige grabenförmige Vertiefung als Erstausnehmung 51 vorgesehen, die parallel zum Randverlauf 35 der Metallschicht 2, 15, 30 verläuft und kuppelartig in der Metallschicht 2, 15, 30 endet. Unter Erstausnehmung 51 versteht der Fachmann insbesondere die vom Randverlauf 35 gesehen erste in die Metallschicht eingelassene und vom Randverlauf 35 beabstandete Ausnehmung 5 bzw. eine erste Gruppe von solchen Ausnehmungen. Es können dabei beispielsweise eine oder mehrere durchgängige Erstausnehmungen 51 nebeneinander parallel zum Randverlauf 35 der Metallschicht 2, 15, 30 in die Metallschicht 2, 15, 30 eingebracht werden. Dabei weist die grabenförmige Vertiefung in der Metallschicht 2, 15, 30 einen ersten Abstand A vom Randverlauf 35 der Metallschicht 2, 15, 30 von 100 µm bis 1000 µm, bevorzugt 110 µm bis 600 µm und besonders bevorzugt von 150 µm bis 400 µm auf. Alle weiteren Ausnehmungen 52, die parallel zur durchgängigen gabenförmigen Vertiefung verlaufen, können durchgängig oder als mehrere nebeneinanderliegende diskrete Ausnehmungen gestaltet werden. Ein zweiter Abstand C aller weiteren Ausnehmungen 52 zur Erstausnehmung 51 weist vorzugsweise ein Wert zwischen 100 µm und 1000 µm, bevorzugt zwischen 110 µm und 600 µm und besonders bevorzugt zwischen 150 µm und 400 µm auf. Die Tiefe der Erstausnehmungen T₅₁ und die Tiefe der weiteren Ausnehmung T₅₂ ist dabei kleiner als die Dicke der Metallschicht und weisen vorzugsweise Werte zwischen 2,5 % und 70 %, bevorzugt zwischen 5 % und 60 % und besonders bevorzugt zwischen 10 % und 55 % der Metallschichtdicke auf.

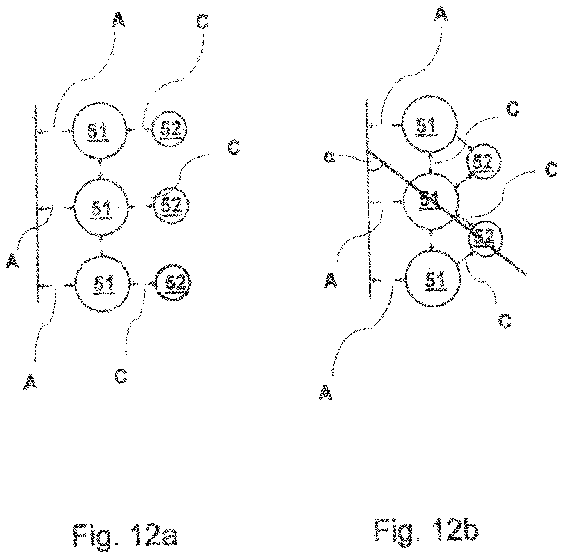

In den **Figuren 12a und 12b** sind jeweils eine Metallschicht 2, 15, 30 für ein Trägersubstrat 1 gemäß einer zehnten und elften Ausführungsform, die nicht alle Merkmale des erfindungsgemäßen Trägersubstrats umfasst, dargestellt. Hierbei sind diskrete Erstausnehmungen 51 vorgesehen, die in Reihe parallel zum Randverlauf 35 der Metallschicht 2, 15, 30 angeordnet sind. Die Erstausnehmungen 51 weisen vorzugsweise einen ersten Abstand A vom Randverlauf 35 der Metallschicht 2, 15, 30 von 100 µm bis 1000 µm, bevorzugt 110 µm bis 600 µm und besonders bevorzugt von 150 µm bis 400 µm auf. Des Weiteren ist es vorzugsweise vorgesehen, dass sich an diese Reihe mit Erstausnehmungen 51 eine Reihe mit weiteren Ausnehmungen 52 oder sogar mehrere Reihen mit diskreten oder auch in Richtung der Haupterstreckungsebenen durchgängigen weiteren Ausnehmungen 52 anschließen. Der zweite Abstand C der Erstausnehmungen 51 zur weiteren Ausnehmung 52 ist vorzugsweise 50 µm bis 1000 µm, in bevorzugter Weise 80 µm bis 600 µm und in besonders bevorzugter Weise 100 µm bis 400 µm. Weiterhin ist es vorzugsweise vorgesehen, dass Mittelpunkte der Erstausnehmung 51 und der weiteren Ausnehmungen 52, parallel zur Haupterstreckungsebene der Metallschicht, entlang einer Linie, die sich gemäß der zehnten Ausführungsform (siehe 10a) senkrecht zum Randverlauf 35 der Metallschicht 2, 15, 30 oder gemäß der elften Ausführungsform unter Bildung eines Winkels α zum Randverlauf 35 der Metallschicht 2, 15, 30, der kleiner ist als 90°, (siehe 12 b) angeordnet sind. Die Tiefe T₅₁ der Erstausnehmungen und die Tiefe der weiteren Ausnehmungen T₅₂ ist dabei kleiner als die Dicke der Metallschicht und sie weisen Werte von 2,5% und 70%, bevorzugt zwischen 5% und 60% und besonders bevorzugt zwischen 10% und 55% beträgt der Metallschichtdicke auf.

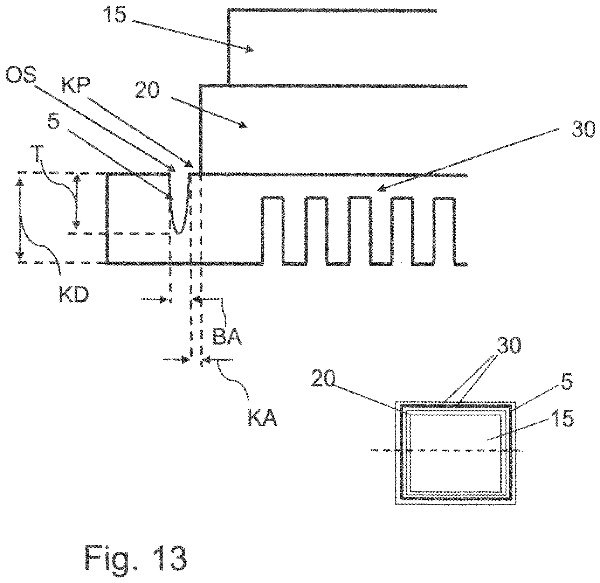

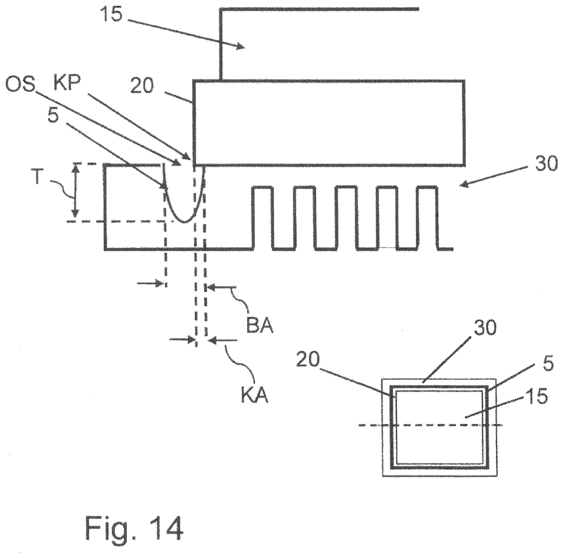

In den **Figuren 13** **und** **14** ist eine Metallschicht für ein Trägersubstrat 1 gemäß einer zweiten bzw. drittem Ausführungsform der vorliegenden Erfindung dargestellt, die im Wesentlichen derjenigen aus Figur 5 entspricht, d. h. die Ausnehmung 5 ist in der Kühlstruktur 30 vorgesehen. Insbesondere ist es hierbei vorgesehen, dass die Kühlstruktur 30 in einer parallel zur Haupterstreckungsebene verlaufenden Richtung, d. h. in einer senkrecht zur Projektionsrichtung verlaufenden Richtung, gegenüber der Primärschicht 10 und/oder der Sekundärschicht 20 übersteht. Vorzugsweise steht die Kühlstruktur 30 mehr als 1 mm gegenüber einer Kante KP, insbesondere der der Kühlstruktur 30 zugewandten Kante KP, der Primärschicht 10 und/oder der Sekundärschicht 20 über. Die als Dehnungsfuge vorgesehene Ausnehmung 5 in der Kühlstruktur 30 verläuft dabei vorzugsweise grabenförmig und beispielsweise geschlossen bzw. durchgehend entlang einem Bereich der Kante KP der Primärschicht 10 und/oder der Sekundärschicht 20, insbesondere innerhalb der Haupterstreckungsebene. Es ist aber auch vorstellbar, dass die sich entlang der Kante KP erstreckende Ausnehmung 5 mit Unterbrechungen versehen ist. Weiterhin ist es vorgesehen, dass sich die Ausnehmung 5 im Wesentlichen parallel zur Kante KP erstreckt. Vorzugsweise ist die Ausnehmung 5 gewölbt ausgestaltet, insbesondere in einem der offenen Seite OS gegenüberliegenden Bereich.

Insbesondere ist es vorgesehen, dass ein Verhältnis der Tiefe T der Ausnehmung 5 zu einer Kühlstrukturdicke KD einen Wert zwischen 0,25 und 0,9, bevorzugt zwischen 0,3 und 0,8 und besonders bevorzugt zwischen 0,45 und 0,7 annimmt. Für die Verhältnisse zwischen 0,45 und 0,7 hat es sich überraschender Weise gezeigt, dass hier die thermomechanische Belastbarkeit während des Bildungsprozesses des Trägersubstrats 1 verbessert ist, ohne dass die Stabilität der Kühlstruktur 30 reduziert wird.

Im Wesentlichen unterscheiden sich die Ausführungsformen aus den Figuren 13 und 14 in Hinblick auf die Positionierung der Ausnehmung 5 in der Kühlstruktur 30. Insbesondere ist es in der Ausführungsform der Figur 13 vorgesehen, dass eine der Primärschicht 10 bzw. der Sekundärschicht 20 zugewandte offene Seite OS vollständig frei liegt, während diese offene Seite OS in der Ausführungsform aus der Figur 14 von der Primärschicht 10 und/oder Sekundärschicht 20 teilweise bedeckt ist. Vorzugsweise nimmt ein Verhältnis zwischen einem bedeckten Bereich der offenen Seite OS zur Breite BA der Ausnehmung 5 einen Wert zwischen 0,05 und 0,8, bevorzugt zwischen 0,1 und und besonders bevorzugt zwischen 0,15 und 0,4 an. Weiterhin ist es vorgesehen, dass
- der Kantenabstand KA einen Wert zwischen -0,5 mm bis 1,5 mm, bevorzugt einen Wert zwischen -0,25 und 0,8 mm und besonders bevorzugt einen Wert zwischen -0,1 bis 0,3 mm annimmt und/oder
- ein Verhältnis vom Kantenabstand KA zu einer in derselben Richtung bemessenen Breite BA der Ausnehmung ein Wert zwischen 0,1 bis 0,9, bevorzugt zwischen 0,25 und 0,75 und besonders bevorzugt zwischen 0,3 und 0,6 annimmt. Negative Werte für den Kantenabstand KA kennzeichnen dabei solche Ausnehmungen, deren einer Rand in Projektionsrichtung gesehen unterhalb der Primärschicht und/oder der Sekundärschicht angeordnet ist.

### Bezugszeichenliste

- 1: Trägersubstrat
- 2: strukturierte Metallfläche
- 4: Bauteilseite
- 5: Ausnehmung
- 6: Kühlseite
- 7: Isograben
- 8: Ätzgraben
- 10: Primärschicht
- 13: Bauteile
- 15: Zwischenschicht
- 16: Kontaktelement
- 17: Verdickung
- 20: Sekundärschicht
- 21: Eingangskanal
- 22: Ausgangskanal
- 30: Kühlstruktur
- 31: Zentralbereich
- 32: Randverlauf
- 33: Hohlkammer
- 34: gestufte Kante
- 35: äußerster Randverlauf
- 38: Füllmaterial
- 41: erste Seite
- 42: zweite Seite
- 51: Erstausnehmung
- 52: weitere Ausnehmung
- ET: Einrücktiefe
- KD: Kühlstrukturdicke
- KA: Kantenabstand
- KP: Kante
- BA: Breite
- OS: offene Seite
- T: Tiefe
- FL: Faltlinie
- P: Projektionsrichtung, bzw. -orientierung
- MD: Schichtdicke
- A: Erster Abstand
- C: Zweiter Abstand
- T₅₁: Tiefe Erstausnehmung
- T₅₂: Tiefe weitere Ausnehmung
- α: Winkel

## Patentansprüche

1. Trägersubstrat (1) für elektrische Bauteile (13), wobei das Trägersubstrat (1) eine aus Keramik gefertigte Primärschicht (10) und mindestens eine an die Primärschicht (10) angebundene Metallschicht (2, 15, 30) aufweist, wobei die mindestens eine Metallschicht (2, 15, 30) auf der der Primärschicht (10) zugewandten Seite mindestens eine Ausnehmung (5) aufweist, wobei die Ausnehmung (5) in der Metallschicht (2, 15, 30) zur Bildung einer Dehnungsfuge in einem Bereich angrenzend an einen Randverlauf (32) der Primärschicht (10) ausgebildet ist, wobei
- die Ausnehmung in der Metallschicht zur Bildung einer Dehnungsfuge in einem Bereich angrenzend an einen Randverlauf der Primärschicht ausgebildet ist, ohne dass die als Dehnungsfuge dienende Ausnehmung von der Primärschicht überdeckt wird oder
- eine zur Primärschicht offene Seite der Aussparung teilweise von der Primärschicht bedeckt ist, **dadurch gekennzeichnet, dass** die Ausnehmung (5) mit einem Füllmaterial befüllt ist, welches einen niedrigeren Ausdehnungskoeffizient und/oder ein höheres E-Modul als ein Material, aus dem die Metallschicht (2, 15, 30) gefertigt ist, aufweist.

2. Trägersubstrat (1) gemäß einem der vorhergehenden Ansprüche, wobei die Ausnehmung (5) als Wölbung, insbesondere als kuppelartige oder teilkuppelartige Wölbung, ausgestaltet ist, und wobei die Wölbung zu der der Primärschicht (10) abgewandten Seite der angebundenen Metallschicht (2, 15, 30) hin gerichtet ist.

3. Trägersubstrat (1) gemäß einem der vorhergehenden Ansprüche, wobei die Ausnehmungen (5) in einer senkrecht zur Haupterstreckungsebene des Trägersubstrats (1) verlaufenden Projektionsrichtung bzw. - orientierung (P) eine durchschnittliche Tiefe (T) aufweisen, die im Verhältnis zur kleinsten Öffnungsweite der Ausnehmung (5), beispielsweise einem Durchmesser bei einer kreisförmigen Ausnehmung oder einer Breite einer grabenförmigen Ausnehmung, vorzugsweise einen Wert zwischen 0,2 und 1,2, bevorzugt zwischen 0,3 und 1,0 und besonders bevorzugt von 0,4 bis 0,8 annimmt..

4. Trägersubstrat (1) gemäß einem der vorhergehenden Ansprüche, wobei die Metallschicht (2, 15, 30) Teil einer Kühlstruktur (30) ist, wobei die Kühlstruktur (30) vorzugsweise unmittelbar an die Primärschicht (10) angebunden ist.

5. Trägersubstrat (1) gemäß einem der vorhergehenden Ansprüche , wobei in einer parallel zur Haupterstreckungsebene verlaufenden Richtung die Ausnehmung (5) in einem Kantenabstand (KA) von einer Kante (KP) der Primärschicht (11) beabstandet angeordnet ist, wobei
- der Kantenabstand (KA) einen Wert zwischen -0,5 mm bis 1,5 mm, bevorzugt einen Wert zwischen -0,25 und 0,8 mm und besonders bevorzugt einen Wert zwischen -0,1 bis 0,3 mm annimmt und/oder
- ein Verhältnis vom Kantenabstand (KA) zu einer in derselben Richtung bemessenen Breite (BA) der Ausnehmung (5) einen Wert zwischen 0,1 bis 0,9, bevorzugt zwischen 0,25 und 0,75 und besonders bevorzugt zwischen 0,3 und 0,6 annimmt.

6. Trägersubstrat (1) gemäß einem der vorhergehenden Ansprüche, wobei ein Verhältnis der Tiefe (T) der Ausnehmung (5) zur Kühlstrukturdicke (KD) einen Wert zwischen 0,25 und 0,9, bevorzugt zwischen 0,3 und 0,8 und besonders bevorzugt zwischen 0,45 und 0,7 annimmt.

7. Verfahren zur Herstellung eines Trägersubstrats (1) gemäß einem der vorhergehenden Ansprüche, umfassend die Schritte:
-- Bereitstellen einer aus Keramik gefertigten Primärschicht (10) und mindestens einer Metallschicht (2, 15, 30)
-- Ausformen, insbesondere Einätzen, von Ausnehmungen (5) in der mindestens einen Metallschicht (2, 15, 30) und
-- Fügen der Primärschicht (10) und der Metallschicht (2, 15, 30), wobei die Metallschicht (2, 15, 30) derart ausgerichtet wird, dass in einem gefertigten Zustand die Ausnehmungen (5) der Primärschicht (10) zugewandt sind.

8. Verfahren gemäß Anspruch 7 wobei zeitlich vor dem Fügen die Metallschicht (2, 15, 30) gefaltet wird.

## Claims

1. A carrier substrate (1) for electrical components (13), wherein the carrier substrate (1) has a primary layer (10) made of ceramic and at least one metal layer (2, 15, 30) bonded to the primary layer (10), wherein the at least one metal layer (2, 15, 30) has at least one recess (5) on the side facing the primary layer (10), wherein the recess (5) in the metal layer (2, 15, 30) is configured to form an expansion joint in a region adjacent to a peripheral course (32) of the primary layer (10), wherein
- the recess in the metal layer is formed to form an expansion joint in an area adjacent to a peripheral course of the primary layer without the recess serving as expansion joint being covered by the primary layer, or
- a side of the clearance that is open towards the primary layer is partially covered by the primary layer, **characterized in that** the recess (5) is filled with a filler material which has a lower coefficient of expansion and/or a higher modulus of elasticity than a material from which the metal layer (2, 15, 30) is made.

2. The carrier substrate (1) according to one of the preceding claims, wherein the recess (5) is configured as a bulge, in particular as a dome-like or partially dome-like bulge, and wherein the bulge is directed towards the side of the bonded metal layer (2, 15, 30) facing away from the primary layer (10).

3. The carrier substrate (1) according to one of the preceding claims, wherein the recesses (5) in a projection direction or orientation (P) running perpendicular to the main extension plane of the carrier substrate (1) have an average depth (T) which is in proportion to the smallest opening width of the recess (5), for example a diameter in the case of a circular void or a width of a trench-shaped void, preferably has a value between 0.2 and 1.2, more preferably between 0.3 and 1.0 and most preferably from 0.4 to 0.8.

4. The carrier substrate (1) according to one of the preceding claims, wherein the metal layer (2, 15, 30) is part of a cooling structure (30), wherein the cooling structure (30) is preferably directly bonded to the primary layer (10).

5. The carrier substrate according to one of the preceding claims, wherein in a direction running parallel to the main extension plane the recess (5) is arranged at an edge distance (KA) from an edge (KP) of the primary layer (11), wherein
- the edge distance (KA) has a value of between -0.5 mm and 1.5 mm, more preferably a value of between -0.25 and 0.8 mm, and most preferably a value of between - 0.1 and 0.3 mm, and/or
- a ratio of the edge distance (KA) to a width (BA) measured in the same direction of the recess (5) has a value between 0.1 and 0.9, more preferably between 0.25 and 0.75, and most preferably between 0.3 and 0.6.

6. The carrier substrate (1) according to one of the preceding claims, wherein a ratio of the depth (T) of the recess (5) to the thickness of the cooling structure (KD) has a value between 0.25 and 0.9, more preferably between 0.3 and 0.8 and most preferably between 0.45 and 0.7.

7. A method for the production of a carrier substrate (1) according to one of the preceding claims, comprising the steps of:
- providing a primary layer (10) made of ceramic and at least one metal layer (2, 15, 30);
- forming, in particular etching, of recesses (5) in the at least one metal layer (2, 15, 30), and
- joining the primary layer (10) and the metal layer (2, 15, 30), wherein the metal layer (2, 15, 30) is aligned in such a way that in a manufactured state the recesses (5) face the primary layer (10).

8. The method according to claim 7, wherein the metal layer (2, 15, 30) is folded before joining.

## Revendications

1. Substrat de support (1) pour des composants électriques (13), le substrat de support (1) comprenant une couche primaire (10) fabriquée en céramique et au moins une couche métallique (2, 15, 30) liée à la couche primaire (10), ladite au moins une couche métallique (2, 15, 30) présentant au moins un évidement (5) sur le côté tourné vers la couche primaire (10), l'évidement (5) dans la couche métallique (2, 15, 30) étant réalisé pour former un joint de dilatation dans une zone adjacente à un tracé de bord (32) de la couche primaire (10),
dans lequel
- l'évidement dans la couche métallique est réalisé pour former un joint de dilatation dans une zone adjacente à un tracé de bord de la couche primaire sans que l'évidement servant de joint de dilatation soit recouvert par la couche primaire, ou
- un côté de l'évidement ouvert vers la couche primaire est partiellement recouvert par la couche primaire,
**caractérisé en ce que**
l'évidement (5) est rempli d'un matériau de remplissage qui présente un coefficient de dilatation plus faible et/ou un module d'élasticité plus élevé qu'un matériau dans lequel la couche métallique (2, 15, 30) est fabriquée.

2. Substrat de support (1) selon la revendication précédente,
dans lequel l'évidement (5) est réalisé comme une voûte, en particulier comme une voûte en forme de coupole ou de partie de coupole, et
la voûte est orientée vers le côté de la couche métallique (2, 15, 30) liée qui est détourné de la couche primaire (10).

3. Substrat de support (1) selon l'une des revendications précédentes,
dans lequel les évidements (5), dans une direction ou orientation de projection (P) perpendiculaire au plan d'extension principal du substrat de support (1), ont une profondeur moyenne (T) qui, par rapport à la plus petite largeur d'ouverture de l'évidement (5), par exemple un diamètre dans le cas d'un évidement circulaire ou une largeur dans le cas d'un évidement en forme de tranchée, prend de préférence une valeur comprise entre 0,2 et 1,2, de préférence entre 0,3 et 1,0 et de manière particulièrement préférée entre 0,4 et 0,8.

4. Substrat de support (1) selon l'une des revendications précédentes,
dans lequel la couche métallique (2, 15, 30) fait partie d'une structure de refroidissement (30), la structure de refroidissement (30) étant de préférence directement liée à la couche primaire (10).

5. Substrat de support (1) selon l'une des revendications précédentes,
dans lequel, dans une direction parallèle au plan d'extension principal, l'évidement (5) est disposé à une distance de bord (KA) d'un bord (KP) de la couche primaire (11), sachant que
- la distance de bord (KA) prend une valeur comprise entre -0,5 mm et 1,5 mm, de préférence une valeur comprise entre -0,25 et 0,8 mm et de manière particulièrement préférée une valeur comprise entre -0,1 et 0,3 mm, et/ou
- un rapport entre la distance de bord (KA) et la largeur (BA) de l'évidement (5), mesurée dans la même direction, prend une valeur comprise entre 0,1 et 0,9, de préférence entre 0,25 et 0,75 et de manière particulièrement préférée entre 0,3 et 0,6.

6. Substrat de support (1) selon l'une des revendications précédentes,
dans lequel un rapport entre la profondeur (T) de l'évidement (5) et l'épaisseur (KD) de la structure de refroidissement prend une valeur comprise entre 0,25 et 0,9, de préférence entre 0,3 et 0,8 et de manière particulièrement préférée entre 0,45 et 0,7.

7. Procédé de fabrication d'un substrat de support (1) selon l'une des revendications précédentes, comprenant les étapes consistant à :
- fournir une couche primaire (10) réalisée en céramique et au moins une couche métallique (2, 15, 30),
- former, en particulier par gravure, des évidements (5) dans ladite au moins une couche métallique (2, 15, 30), et
- assembler la couche primaire (10) et la couche métallique (2, 15, 30), la couche métallique (2, 15, 30) étant orientée de telle sorte que, dans un état fabriqué, les évidements (5) sont tournés vers la couche primaire (10).

8. Procédé selon la revendication 7,
dans lequel la couche métallique (2, 15, 30) est pliée avant d'être assemblée.
